# EUROPEAN PATENT SPECIFICATION

(11) **EP 0 560 045 B1**
(45) Date of publication and mention of the grant of the patent: **12.05.1999**
(21) Application number: 93101671.1
(22) Date of filing: 03.02.1993
(51) Int. Cl.: C22C 45/08, C22C 21/00

(54) **Highly corrosion resistant amorphous aluminum alloy**
Hochkorrosionsbeständige amorphe Aluminium-Legierung
Alliage d'aluminium amorphe à haute résistance à la corrosion

(30) Priority: 17.02.1992 JP 29362/92
(43) Date of publication of application: 15.09.1993
(73) Proprietor: Hashimoto, Koji, Sendai-shi Miyagi (JP); YKK CORPORATION, Chiyoda-ku, Tokyo (JP)
(72) Inventor: Hashimoto, Koji, Sendai-shi, Miyagi (JP); Kim, Jinhan, Tosu-shi, Saga (JP); Yoshioka, Hideaki, Kurobe-shi, Toyama (JP); Habazaki, Hiroki, Sendai-shi, Miyagi (JP); Kawashima, Asahi, Sendai-shi, Miyagi (JP); Asami, Katsuhiko, Sendai-shi, Miyagi (JP)
(74) Representative: Patentanwälte Leinweber & Zimmermann

(56) References cited:
- EP-A- 0 394 825
- EP-A- 0 406 770
- EP-A- 0 458 029
- FR-A- 2 651 246

## Description

### BACKGROUND OF THE INVENTION

### 1. Field of the Invention

The present invention relates to novel amorphous aluminum alloys which have excellent characteristics such as ultrahigh corrosion resistance and high corrosion resistance at high temperatures and which are useful in a variety of fields including domestic uses as well as industrial uses such as a chemical process plant.

### 2. Description of the Prior Art

The present inventors have found various amorphous alloys having high corrosion resistance that could never have been embodied with any of crystalline alloys. These amorphous alloys are broadly classified into metal-semimetal alloys and metal-metal alloys. The metal-semimetal alloy comprises an iron group element such as Fe, Co or Ni and a semimetal element such as P, C, B or Si in an amount of 10 to 25 atomic % which is necessary for amorphization. The high corrosion resistance of the metal-semimetal alloy is embodied by the addition of Cr thereto. On the other hand, the metal-metal alloy comprises an element such as Fe, Co, Ni, Cu or Al and a valve metal belonging to the group IVa or Va metals, such as Ta, Nb, Zr or Ti. The corrosion resistance of the metal-metal alloy is due to the valve metal which constitutes the amorphous alloy. Among the alloys, those containing Ta or Nb of the group Va is extremely corrosion resistant.

As mentioned hereinbefore, the amorphous alloy containing an effective amount of Cr for high corrosion resistance entails a semimetal element for amorphization, while the amorphous metal-metal alloy has been embodied only by those comprising the elements belonging to the different groups each lying relatively apart from each other in the Periodic Table. On the other hand, Al is attacked by both acid and alkali and easily subjected to pitting corrosion in the presence of chlorine ions even in a neutral environment. It is expected that a highly corrosion resistant aluminum alloy may be obtained if a single phase alloy is materialized by the addition of Cr, which plays a role in attaining corrosion resistance, or a corrosion resistant element other than Cr to relatively less corrosion resistant Al.

An alloy is usually crystalline in a solid state, but is brought into an amorphous state that is similar to liquid structure without having any crystallinity by, for example, ultrarapid cooling solidification of an alloy having a specific composition from the molten state or sputtering deposition by the use of a given target, that is, by a method wherein any long period regularity in the atomic arrangement is not formed in the course of solid formation. The alloy thus obtained is termed "amorphous alloy". An amorphous alloy is a homogeneous single-phase alloy consisting of a supersaturated solid solution, possesses a markedly high strength as compared with conventional practical metals and exerts a variety of characteristics such as extraordinarily high corrosion resistance depending upon the composition thereof.

The present inventors have created new amorphous alloys and made an extensive research on the properties. As a result, they have found that an amorphous alloy composed of a low melting metal and a high melting metal can be produced by the sputtering method which can dispense with melting in the course of alloy formation, and succeeded in the production of amorphous alloys each comprising a group IVa, Va or VIa metal, such as Ti, Zr, Nb, Ta, Mo or W, and a group Ib or IIIb metal, such as Cu or Al. Some of them were filed as Japanese Patent Application Nos. 51568/1988 (filed on the basis of Application No. 103296/1987), 51567/1988 and 260020/1988 which have been laid open to public inspection under Laid-Open Nos. 25934/1989, 225737/1989 and 107750/1990, respectively.

They have continued the research and made an attempt to produce a highly corrosion resistant metal-metal amorphous alloy comprising metals belonging to the close groups of the Periodic Table. As a result, they have succeeded in the production of amorphous alloys, one comprising Ti or Zr of the group IVa and Cr of the group VIa, and the other comprising Ta or Nb of the group Va and Cr of the group VIa, and have applied for patents as Japanese Patent Application Nos. 138575/1991 (Laid-Open No. 337053/1992) and 3-267542.

WO 91/14013 corresponding to EP-A-0 474 880 describes an aluminum-chromium based alloy containing 10 to 25 atomic% of Cr, and 0.1 to 5.0 atomic% of at least one element selected from a group of Fe and Ni. Said alloy has an amorphous structure due to the presence of Fe and/or Ni.

EP-A-0 458 029 discloses a corrosion resistant aluminum-based alloy which is composed of a compound having a composition consisting of the general formula:

AlₐM_{b}Mo_{c}X_{d}Crₑ

wherein:
- M: is one or more metal elements selected from the group consisting of Ni, Fe, Co, Ti, V, Mn, Cu and Ta;
- X: is Zr or a combination of Zr and Hf; and a, b, c, d and e are, in atomic percentages;
50% ≤ a ≤ 89%, 1% ≤ b ≤ 25%, 2% ≤ c ≤ 15%,
4% ≤ d ≤ 20% and 4% ≤ e ≤ 20%,
said compound being at least 50% by volume composed of an amorphous phase.

EP-A-0 394 825 discloses a corrosion resistant aluminum-based alloy consisting of a compound which has a composition represented by the general formula:

AlₐM_{b}Mo_{c}Hf_{d}Crₑ

wherein
M is one or more metal elements selected from Ni, Fe and Co, and a, b, c, d and e are atomic percentages falling within the following ranges:
50% ≤ a ≤ 88%, 2% ≤ b ≤ 25%, 2% ≤ c ≤ 15%,
4% ≤ d ≤ 20% and 4% ≤ e ≤ 20%,
the compound being at least 50% by volume composed of an amorphous phase.

Aluminium Taschenbuch, 14.ed., 1983, p. 1000, discloses information about impurities of commercially available aluminum.

The present inventors have further continued the research and investigated the production conditions for amorphous alloys. As a result, they have succeeded in the production of a highly corrosion resistant amorphous aluminum alloy consisting of Al, that is, a low melting-point and light-weight metal with Cr which may be partially substituted by Mo and/or W, and other amorphous aluminum alloys containing, in addition to Al and Cr which may be partially substituted by Mo and/or W, various elements which further improve corrosion resistance, thus accomplishing the present invention.

### SUMMARY OF THE INVENTION

The present invention provides an amorphous aluminum alloy which is obtained by adding to Al, Cr which may at least partially be substituted by Mo and/or W that is indispensable for imparting a high corrosion resistance to an amorphous alloy comprising an-iron group element as a principal component and Ta, Nb, Zr, Ti or the like that is effective in materializing a corrosion resistant metal-metal amorphous alloy, and at the same time, a highly corrosion resistant amorphous aluminum alloy which is obtained by adding various elements to said alloys.

More specifically, the present invention provides highly corrosion resistant amorphous aluminum alloys as laid down in claims 1 to 4.

### BRIEF DESCRIPTION OF THE DRAWINGS

FIG. 1 is a schematic illustration of one example of the sputtering device to be used for preparing the amorphous alloy of the present invention.

FIG. 2 is a schematic illustration of another example of the sputtering device to be used for preparing the amorphous alloy of the present invention.

### DETAILED DESCRIPTION OF THE PREFERRED EMBODIMENTS

The present invention consists of four aspects as claimed in claims 1 through 4.

A sputtering method is one of the methods for producing an amorphous alloy. An amorphous alloy is produced by the sputtering method in which a target consisting of a plurality of crystalline phases instead of a single phase which have the same average composition as that of the amorphous alloy to be produced is prepared by sintering, melting or the like and brought into use, or alternatively a metallic plate consisting of the principal components of the amorphous alloy to be produced and having the element to be alloyed placed thereon or embedded therein is employed.

In the present invention, the above-mentioned method is utilized and improved as will be described hereunder.

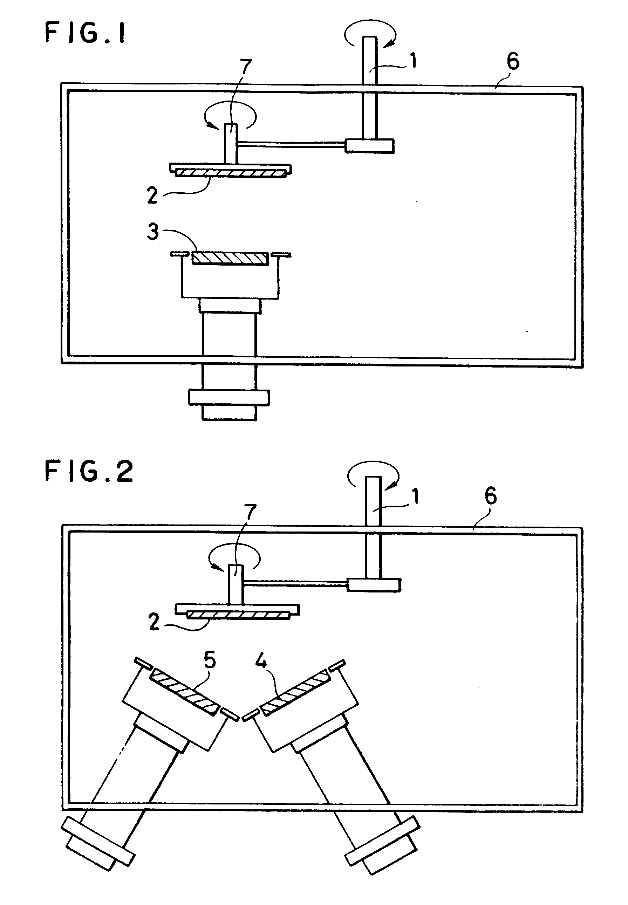

Although it is not so easy to produce a Cr-Al alloy target by the melting method or the like, a highly corrosion resistant amorphous Al-Cr alloy is obtained by the sputtering method using a target comprising an Al plate and a Cr lump placed thereon or embedded therein. In this method, for the purpose of preventing nonuniformity from occurring in the amorphous alloy to be formed depending on the position, it is desirable that, for example, as shown in FIG. 1, a plurality of substrates 2 in a sputtering device chamber 6 be allowed to revolve about the central axis 1 of the chamber and, at the same time, the substrates themselves be allowed to rotate on their axes 7. Moreover, in order to vary the compositions of the amorphous alloys to be formed in a wide range, as shown in FIG. 2, for example, one target 4 made of Cr and the other target 5 made of Al are obliquely placed and allowed to simultaneously act by means of two power sources while regulating each output, and the substrate 2 is located near the intersection of normals of the centers of the two targets 4 and 5. By the above-mentioned method, the concentration of each element in the amorphous alloy to be formed can be arbitrarily varied. Further, as a variation of this method, by the combination of various targets with this method, for example, by the use of an Al-plate target having Ta, Nb, Ti, Zr, Fe, Co, Ni, Cu, Mo, W or the like embedded therein, it is possible to obtain highly corrosion resistant amorphous alloys such as Cr-Al, Cr-Mo-Al, Cr-W-Al, Cr-Mo-W-Al, Cr-Ta-Al, Cr-Nb-Al, Cr-Ta-Nb-Al, Cr-Ta-Ti-Al, Cr-Ta-Zr-Al, Cr-Nb-Ti-Al, Cr-Nb-Zr-Al, Cr-Ta-Nb-Ti-Al, Cr-Ta-Nb-Zr-Al, Cr-Ta-Nb-Ti-Zr-Al, Cr-Mg-Al, Cr-Fe-Al, Cr-Co-Al, Cr-Ni-Al, Cr-Cu-Al, Cr-Ta-Fe-Al, Cr-Ta-Co-Al, Cr-Ta-Ni-Al, Cr-Ta-Cu-Al, Cr-Ta-Mo-Al, Cr-Ta-W-Al, Cr-Nb-Fe-Al, Cr-Nb-Co-Al, Cr-Nb-Ni-Al, Cr-Nb-Cu-Al, Cr-Nb-Mo-Al and Cr-Nb-W-Al. In the method wherein two targets are simultaneously employed, both revolution and rotation of the substrate are particularly necessary in order to form a uniform amorphous alloy.

The amorphous alloy having the composition of the present invention which is prepared by the sputtering method is a single-phase amorphous alloy in which the above-mentioned elements form a homogeneous solid solution. A protective film assuring an extreme uniformity and high corrosion resistance can be formed onto the homogeneous solid solution amorphous alloy. Since a metallic material is easily dissolved in a solution which is extremely corrosive and poor in oxidative power, such as hydrochloric acid, it is necessary that the metallic material have a capability of forming a secure protective film in order that it may be used in such an environment. This situation can be materialized by the formation of an alloy containing required amounts of effective elements. In the case of a crystalline metal, however, the addition of large amounts of various alloying elements thereto sometimes gives rise to a polyphase structure having different chemical properties without forming a uniform protective film securing high corrosion resistance, thereby failing to achieve a prescribed corrosion resistance. In addition, the occurrence of chemical nonuniformity is rather detrimental to corrosion resistance.

On the other hand, since the amorphous alloy of the present invention is a homogeneous solid solution and uniformly contains effective elements in amounts required for the formation of a secure protective film, the alloy exhibits sufficiently high corrosion resistance by virtue of the uniformly formed protective film. The condition to be given to a metallic material capable of withstanding a severely corrosive environment is a capability of uniformly forming a highly stable protective film on the material even in a nonoxidative environment. The aforementioned requirement is materialized by the alloy compositions according to the present invention. Moreover, amorphous alloys having intricate compositions can be formed in a single-phase solid solution and the formation of a uniform protective film can be assured.

Now, the reasons for restricting the compositions of the alloys of the present invention will be described.

Cr is an element which constitutes an amorphous structure when it coexists with Al and must be contained in an amount of 7 to not more than 55 atomic % in order to form an amorphous structure by the sputtering method. According to the present invention, therefore, Cr must be contained in an amount of 7 to not more than 55 atomic %, however, Mo and W belong to the group VIa elements as is t e case with Cr and, therefore, can substitute Cr and are effective in improving the corrosion resistance of the alloy in an acid. In order to constitute the amorphous structure, the total amount of Cr and at least one of Mo and W is required to be 7 to not more than 55 atomic %. This is the reason for restricting the alloy composition in claim 1 of the present invention.

When Cr or Cr and some of the group VIa elements, i.e., at least one of Mo and W, are replaced with at least one element selected from among Ta, Nb, Zr and Ti, the corrosion resistance of an alloy is further enhanced. Though Ta, Nb, Zr and Ti are elements constituting amorphous alloys together with Al, failure to add a large amount of Ta, Nb, Zr and Ti does not constitute an amorphous structure in the absence of Cr. Accordingly, even when Ta, Nb, Zr and Ti are contained in an alloy, Cr in claim 2, must be contained in an amount of 7 atomic % or more. In the case of Cr alone or the combination of Cr with the other group VIa elements, a large amount of expensive Ta, Nb, Zr and Ti need not be contained. Thus, in the case where Cr alone or the combination of Cr with the other group VIa elements is contained in an amount of 7 atomic % or more in claim 2, the total amount of at least one element selected from among Ta, Nb, Zr and Ti and the group VIa elements shall be 55 atomic % or less.

On the other hand, even if some of the group VIa elements is replaced with Mg, Fe, Co, Ni and Cu in the alloy comprising Cr or the combination of Cr with the other group VIa elements and Al, an amorphous alloy is constituted. However, in order to form an amorphous alloy and secure high corrosion resistance, 7 atomic % or more of Cr alone or the combination of Cr with the other group VIa elements must be contained in the alloy. Further, in order to secure an amorphous structure, it is necessary to restrict the total amount of Cr or the combination of Cr with the other group VIa elements and at least one element selected from among Mg, Fe, Co, Ni and Cu to 55 atomic % or less. This is the reason for restricting the total amount of at least one element selected from among Mg, Fe, Co Ni and Cu and the group VIa elements to 55 atomic % or less in claim 4 containing Cr and the other group VIa elements. By the same reason, the total amount of Cr or the combination of Cr with the other group VIa elements and at least one element selected from among Mg, Fe, Co, Ni and Cu is limited to more than 7 to not more than 55 atomic % in claim 3 containing at least one element selected from among Ta, Nb, Zr and Ti.

Now the method for producing amorphous alloys will be described with reference to Examples.

### Example 1

Targets were prepared by placing 1 to 5 Cr discs, each having a diameter of 20 mm and a thickness of 1 mm, on an Al disc with a diameter of 100 mm and a thickness of 6 mm in such a manner that the centers of the Cr discs were arranged on the circumference of a circle having a radius of 29 mm and the same center as that of the Al disc. The thus prepared targets were used in the following sputtering. Each of substrates made of aluminum or glass was subjected to sputtering deposition at an output of about 400 W while being revolved and rotated by the use of the apparatus as shown in FIG. 1 maintained at a vacuum of 2 x 10⁻⁴ Torr with argon allowed to flow at a flow rate of 5 ml/min. As a result of X-ray diffractometry, the alloys thus formed were confirmed to be amorphous, and analysis with an X-ray microanalyzer revealed that the alloy compositions were 7 atomic % Cr-Al, 18 atomic % Cr-Al, 31 atomic % Cr-Al, 40 atomic % Cr-Al and 55 atomic% Cr-Al, respectively. Each of the alloys was self-passivated in a neutral solution containing Cl⁻ ions at 30°C and the weight loss thereof due to corrosion was undetectable even after a period of one month of immersion therein and even by the use of a microbalance.

### Example 2

Each of substrates made of aluminum or glass was subjected to sputtering deposition while being revolved and rotated by the use of the apparatus as shown in FIG. 2 maintained at a vacuum of 1 x 10⁻⁴ to 4 x 10⁻⁴ Torr with argon allowed to flow at a flow rate of 5 ml/min and equipped inside with a Cr disc and an Al disc, both having a diameter of 100 mm and a thickness of 6 mm, as the targets. As a result of X-ray diffractometry, the alloy thus formed was confirmed to be amorphous, and analysis with an X-ray microanalyzer proved that the alloy was 43 atomic % Cr-Al alloy. The alloy was self-passivated in a neutral solution containing Cl⁻ ions at 30°C, and the weight loss thereof due to corrosion was undetectable even after one month of immersion therein and even by the use of a microbalance.

### Example 3

Targets were prepared by placing a Cr disc and discs made of various metals or alloys, each having a diameter of 20 mm and thickness of 1 mm, on an Al disc with a diameter of 100 mm and a thickness of 6 mm in such a manner that the centers of the Cr or other discs were arranged on the circumference of a circle having a radius of 29 mm and the same center as that of the Al disc. The thus prepared targets were used in the following sputtering. Each of substrates made of aluminum or glass was subjected to sputtering deposition while being revolved and rotated by the use of the apparatus as shown in FIG. 1 maintained at a vacuum of 5 x 10⁻³ to 1 x 10⁻⁴ Torr with argon allowed to flow at a flow rate of 5 ml/min. As a result of X-ray diffractometry, the alloys thus formed were confirmed to be amorphous. The alloy compositions determined by the analysis with an X-ray microanalyzer are given in Table 1. These alloys were subjected to a corrosion test in a buffer solution containing 0.5N NaCl at 30°C and pH 8.4, to reveal that, as shown in Table 1, they were self-passivated and highly corrosion resistant alloys.

**Table 1**

| Alloy (atomic %) | Corrosion state |
|---|---|
| Al-7Cr | unchanged |
| Al-18Cr | unchanged |
| Al-31Cr | unchanged |
| Al-40Cr | unchanged |
| Al-43Cr | unchanged |
| Al-55Cr | unchanged |
| Al-6Cr-1Mo* | unchanged |
| Al-4Cr-3W* | unchanged |
| Al-22Cr-18W* | unchanged |
| Al-7Cr-20Ta* | unchanged |
| Al-7Cr-30Ti* | unchanged |
| Al-32Cr-14Zr* | unchanged |
| Al-25Cr-3Nb-8Ti* | unchanged |
| Al-28Cr-11Mg | unchanged |
| Al-21Cr-13Fe | unchanged |
| Al-25Cr-22Co | unchanged |
| Al-23Cr-22Ni | unchanged |
| Al-17Cr-12Fe-13Cu | unchanged |
| Al-17Cr-5Ta-11Ni-2Cu* | unchanged |
| Al-20Cr-21Ta-5Fe-7Ni* | unchanged |
| Al-8Cr-14Nb-3Co-11Cu* | unchanged |
| Al-3Cr-4Mo-30Ta | unchanged |
| Al-5Cr-10W-15Zr | unchanged |
| Al-7Cr-2Mo-2W-12Ni* | unchanged |
| Al-13Cr-7W-3Mg* | unchanged |
| Al-25Cr-5Mo-15Fe* | unchanged |

| | |
|---|---|
| * Examples according to the invention | |

As detailed hereinbefore, the amorphous alloy according to the present invention is one containing Al and Cr as the essential components and easily producible by the sputtering method. It is also a corrosion resistant alloy which is self-passivated by the formation of a stable protective film even in a Cl⁻ ion-containing solution which is a severe corrosive environment for Al.

## Claims

1. A highly corrosion resistant amorphous aluminum alloy with the general formula
MₐCr_{b}Al_{bal}
with M being at least one of Mo and W and a and b being, in atomic%, a ≥ 1 and 7 ≤ a + b ≤ 55.

2. A highly corrosion resistant amorphous aluminum alloy with the general formula
Cr_{c}N_{d}Al_{bal}
with N being at least one selected from the group consisting of Ta, Nb, Zr and Ti; and c and d being, in atomic%, c ≥ 7, d ≥ 11 and 18 ≤ c + d ≤ 55.

3. A highly corrosion resistant amorphous aluminum alloy with the general formula
Cr_{c}NₑP_{f}Al_{bal}
with N being at least one selected from the group consisting of Ta, Nb, Zr and Ti; P being at least one selected from the group consisting of Mg, Fe, Co, Ni and Cu; and c, e and f being, in atomic%, c ≥ 7, e ≥ 5, f ≥ 13 and 25 ≤ c + e + f ≤ 55.

4. A highly corrosion resistant amorphous aluminum alloy with the general formula
M_{g}CrₕPᵢAl_{bal}
with M being at least one of Mo and W; P being at least one selected from the group consisting of Mg, Fe, Co, Ni and Cu; and g, h and i being, in atomic%, g ≥ 4, i ≥ 12, g + h ≥ 7 and 16 ≤ g + h + i ≤ 55.

## Patentansprüche

1. Hochkorrosionsbeständige amorphe Aluminiumlegierung mit folgender allgemeiner Formel:
MₐCr_{b}Al_{bal}
wobei M mindestens eines von Mo und W ist, und für a und b in Atom-% gilt: a ≥ 1 und 7 ≤ a+b ≤ 55.

2. Hochkorrosionsbeständige amorphe Alummiumlegierung mit folgender allgemeiner Formel:
Cr_{c}N_{d}Al_{bal}
wobei N mindestens eines ist, das aus der Gruppe gewählt ist, die aus Ta, Nb, Zr und Ti besteht; und für c und d in Atom-% gilt: c ≥ 7 , d ≥ 11 und 18 ≤ c+d ≤ 55.

3. Hochkorrosionsbeständige amorphe Aluminiumlegierung mit folgender allgemeiner Formel:
Cr_{c}NₑP_{f}Al_{bal}
wobei N mindestens eines ist, das aus der Gruppe gewählt ist, die aus Ta, Nb, Zr und Ti besteht; P mindestens eines ist, das aus der Gruppe gewählt ist, die aus Mg, Fe, Co, Ni und Cu besteht; und für c, e und f in Atom-% gilt: c ≥ 7 , e ≥ 5 , f ≥ 13 und 25 ≤ c + e + f ≤ 55.

4. Hochkorrosionsbeständige amorphe Aluminiumlegierung mit folgender allgemeiner Formel:
M_{g}CrₕPᵢAl_{bal}
wobei M mindestens eines von Mo und W ist; P mindestens eines ist, das aus der Gruppe gewählt ist, die aus Mg, Fe, Co, Ni und Cu besteht; und für g, h und i in Atom-% gilt: g ≥ 4 , i ≥ 12 , g + h ≥ 7 und 16 ≤ g + h + i ≤ 55.

## Revendications

1. Alliage d'aluminium amorphe, fortement résistant à la corrosion, de formule générale :
MₐCr_{b}Al_{comp}
dans laquelle M est au moins un élément choisi parmi Mo et W et a et b sont des pourcentages atomiques tels que a ≥ 1 et 7 ≤ a + b ≤ 55.

2. Alliage d'aluminium amorphe, fortement résistant à la corrosion, de formule générale :
Cr_{c}N_{d}Al_{comp}
dans laquelle N est au moins un élément choisi dans le groupe formé par Ta, Nb, Zr et Ti et c et d sont des pourcentages atomiques tels que c ≥ 7, d ≥ 11 et 18 ≤ c + d ≤ 55.

3. Alliage d'aluminium amorphe, fortement résistant à la corrosion, de formule générale :
Cr_{c}NₑP_{f}Al_{comp}
dans laquelle N est au moins un élément choisi dans le groupe formé par Ta, Nb, Zr et Ti, P est au moins un élément choisi dans le groupe formé par Mg, Fe, Co, Ni et Cu et c, e et f sont des pourcentages atomiques tels que c ≥ 7, e ≥ 5, f ≥ 13 et 25 ≤ c + e + f ≤ 55.

4. Alliage d'aluminium amorphe, fortement résistant à la corrosion, de formule générale :
M_{g}CrₕPᵢAl_{comp}
dans laquelle M est au moins un élément choisi parmi Mo et W, P est au moins un élément choisi dans le groupe formé par Mg, Fe, Co, Ni et Cu et g, h et sont des pourcentages atomiques tels que g ≥ 4, i ≥ 12 g + h ≥ 7 et 16 ≤ g +h +i ≤ 55.
